# EUROPEAN PATENT APPLICATION

(11) **EP 4 560 631 A1**
(43) Date of publication of application: **28.05.2025**
(21) Application number: 24214734.6
(22) Date of filing: 22.11.2024
(51) Int. Cl.: G11C 5/04, G11C 7/10, H01L 23/00, G11C 5/06

(54) **STORAGE DEVICE HAVING BUFFER CHIP INCLUDING INPUT/OUTPUT MACROS**

(30) Priority: 24.11.2023 KR 20230165008
(71) Applicant: SK hynix Inc., Bubal-eub Icheon-si Gyeonggi-do 17336 (KR)
(72) Inventor: HWANG, Min Soon, 17336 Icheon-si, Gyeonggi-do (KR); LEE, Dong Sop, 17336 Icheon-si, Gyeonggi-do (KR)
(74) Representative: Isarpatent

(57) **Abstract**

A storage device comprises a memory chip, a controller to control the memory chip, and a buffer chip to transfer a plurality of signals between the controller and the memory chip. The buffer chip comprises a plurality of input/output macros. Each of the plurality of input/output macros comprises an external input/output unit to receive a signal from the controller and an internal input/output unit to transmit the signal to the memory chip. Each of the external input/output unit and the internal input/output unit is electrically connected with a bump that overlaps an area of each of the plurality of input/output macros.

## Description

### CROSS-REFERENCE TO RELATED APPLICATION

The present application claims priority under 35 U.S.C. §119(a) to Korean Patent Application No. 10-2023-0165008 filed in the Korean Intellectual Property Office on November 24, 2023, which is incorporated herein by reference in its entirety.

### BACKGROUND

### 1. Technical Field

Various embodiments of the disclosed technology generally relate to a buffer chip, a memory package, and a storage device.

### 2. Related Art

A storage device may include at least one memory chip including a plurality of memory cells which store data. The storage device may include a controller which controls the memory chip.

For example, the controller may control an operation of writing data to the memory chip or reading or erasing data written to the memory chip.

The controller may transmit, to the memory chip, a signal such as a command or data for controlling the memory chip. The controller may receive data read from the memory chip.

Capacitance may be formed in a path through signals that are transmitted and received between the controller and the memory chip. Due to such capacitance, there is a problem that signal transmission and reception performance between the controller and the memory chip may deteriorate.

### SUMMARY

Various embodiments of the disclosed technology are directed to providing measures capable of improving signal transmission and reception performance between at least one memory chip and a controller included in a storage device implementing a package bump disposition structure.

In an embodiment, a storage device may include: at least one memory chip; a controller configured to control the at least one memory chip; and a buffer chip configured to transfer a plurality of signals between the controller and the at least one memory chip, wherein the buffer chip comprises a plurality of input/output macros, each of the plurality of input/output macros comprises an external input/output unit which receives a signal from the controller and an internal input/output unit which transmits the signal to the at least one memory chip, and each of the external input/output unit and the internal input/output unit is electrically connected with a bump that overlaps an area of each of the plurality of input/output macros.

In an embodiment, a memory package may include: a package substrate; at least one memory chip on the package substrate; and a buffer chip located on the package substrate and comprising a plurality of input/output macros which transmit and receive signals to and from the at least one memory chip, wherein each of the plurality of input/output macros comprises an external input/output unit which receives a signal from outside the buffer chip and an internal input/output unit which is electrically connected to the external input/output unit in an area of each of the plurality of input/output macros and transmits the signal to the at least one memory chip.

In an embodiment, a storage device trained to reduce deviations in delay of signals may include: at least one memory package having a signal interface trained to reduce input and output signal delay; and a controller configured to control the at least one memory package, wherein the at least one memory package further includes at least one memory chip and a buffer chip for implementing the signal interface between the at least one memory chip and the controller.

According to the embodiments of the disclosed technology, by improving signal transmission and reception performance between a controller and a memory chip, it is possible to enhance the operating speed and reduce the power consumption of a storage device.

### BRIEF DESCRIPTION OF THE DRAWINGS

FIG. 1 is a diagram illustrating an example of the schematic configuration of a storage device according to an embodiment of the disclosure.
FIG. 2 is a diagram illustrating an example of the schematic configuration of a memory chip included in the storage device according to an embodiment of the disclosure.
FIG. 3 is a diagram illustrating an example of the schematic configuration of a buffer chip included in the storage device according to an embodiment of the disclosure.
FIG. 4 is a diagram illustrating an example of a method of training the buffer chip which transfers signals to be transmitted and received between a controller and the memory chip in the storage device according to an embodiment of the disclosure.
FIG. 5 is a diagram illustrating an example of a structure in which input/output macros are arranged in the buffer chip according to an embodiment of the disclosure.
FIGS. 6 and 7 are diagrams illustrating examples of input/output macros included in the buffer chip according to an embodiment of the disclosure.
FIG. 8 is a diagram illustrating examples of control blocks included in the buffer chip according to an embodiment of the disclosure.
FIG. 9 is a diagram illustrating another example of the structure in which input/output macros are arranged in the buffer chip according to an embodiment of the disclosure.
FIG. 10 is a diagram illustrating an example of a structure in which the buffer chip and the memory chip are connected in a memory package according to an embodiment of the disclosure.

### DETAILED DESCRIPTION

In the following description of examples or embodiments of the present disclosure, reference will be made to the accompanying drawings in which it is shown by way of illustration specific examples or embodiments that can be implemented, and in which the same reference numerals and signs can be used to designate the same or like components even when they are shown in different accompanying drawings from one another. Further, in the following description of examples or embodiments of the present disclosure, detailed descriptions of well-known functions and components incorporated herein will be omitted when it is determined that the description may make the subject matter in some embodiments of the present disclosure rather unclear. The terms such as "including", "having", "containing", "constituting", "made up of', and "formed of" used herein are generally intended to allow other components to be added unless the terms are used with the term "only". As used herein, singular forms are intended to include plural forms unless the context clearly indicates otherwise.

Terms, such as "first", "second", "A", "B", "(A)", or "(B)" may be used herein to describe elements of the present disclosure. Each of these terms is not used to define essence, order, sequence, or number of elements etc., but is used merely to distinguish the corresponding element from other elements.

When it is mentioned that a first element "is connected or coupled to", "contacts or overlaps" etc. a second element, it should be interpreted that, not only can the first element "be directly connected or coupled to" or "directly contact or overlap" the second element, but a third element can also be "interposed" between the first and second elements, or the first and second elements can "be connected or coupled to", "contact or overlap", etc. each other via a fourth element. Here, the second element may be included in at least one of two or more elements that "are connected or coupled to", "contact or overlap", etc. each other.

When time relative terms, such as "after," "subsequent to," "next," "before," and the like, are used to describe processes or operations of elements or configurations, or flows or steps in operating, processing, manufacturing methods, these terms may be used to describe nonconsecutive or non-sequential processes or operations unless the term "directly" or "immediately" is used together.

In addition, when any dimensions, relative sizes etc. are mentioned, it should be considered that numerical values for elements or features, or corresponding information (e.g., level, range, etc.) include a tolerance or error range that may be caused by various factors (e.g., process factors, internal or external impact, noise, etc.) even when a relevant description is not specified. Further, the term "may" fully encompasses all the meanings of the term "can".

Hereinafter, various embodiments of the present disclosure will be described in detail with reference to accompanying drawings.

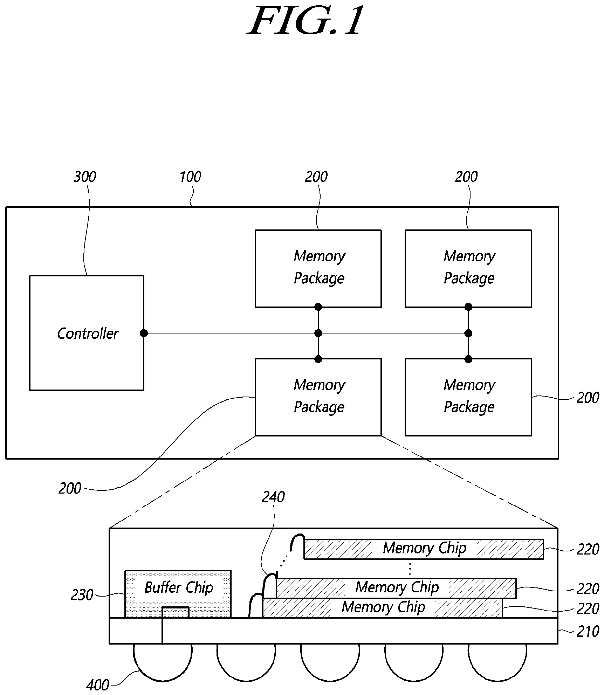

FIG. 1 is a diagram illustrating an example of the schematic configuration of a storage device 100 according to an embodiment of the disclosure.

Referring to FIG. 1, the storage device 100 according to an embodiment of the disclosure may include at least one memory package 200. The storage device 100 may include a controller 300 that controls the memory package 200.

The memory package 200 may include at least one memory chip 220. For example, the memory chip 220 may be disposed on a package substrate 210. The memory chip 220 may be electrically connected to the package substrate 210 through package bumps (not illustrated).

The memory package 200 may include a buffer chip 230, which transfers a signal received from the outside such as the controller 300 to the memory chip 220.

The buffer chip 230 may be disposed on the package substrate 210. The buffer chip 230 may be electrically connected to the package substrate 210 through the package bumps. The buffer chip 230 may be electrically connected to the memory chip 220 through connection wires 240.

The buffer chip 230 may be electrically connected to the controller 300 and so on through printed circuit bumps 400, which are located under the package substrate 210. Although not illustrated in FIG. 1, the controller 300 and the memory package 200 included in the storage device 100 may be disposed on a printed circuit board (not illustrated). The memory package 200 on the printed circuit board may be electrically connected to the printed circuit board through the printed circuit bumps 400. The controller 300 on the printed circuit board may be electrically connected to the printed circuit board through the printed circuit bumps 400, and may be electrically connected to the memory package 200.

For example, the buffer chip 230 may reduce the delay of a signal received from the controller 300 or reduce a deviation in delay between different signals, and may transfer the signal or the signals to the memory chip 220.

A plurality of memory chips 220 may be included in the memory package 200. For example, the plurality of memory chips 220 may be disposed in a stacked structure.

For example, the memory chip 220 may be implemented into various types such as a NAND flash memory, a 3D NAND flash memory, a NOR flash memory, a resistive random access memory (RRAM), a phase-change random access memory (PRAM), a magnetoresistive random access memory (MRAM), a ferroelectric random access memory (FRAM) and a spin transfer torque random access memory (STT-RAM). The memory chip 220 may be implemented into a three-dimensional array structure. The embodiment of the disclosed technology may be applied to not only a flash memory in which a charge storage layer is configured as a floating gate but also a charge trap flash in which a charge storage layer is configured as an insulating film.

The memory chip 220 may include a plurality of memory blocks (or storage blocks).

The memory chip 220 may operate in response to control of the controller 300. Operations of the memory chip 220 may include, for example, a program operation (also referred to as a "write operation"), an erase operation and a read operation.

The controller 300 may control program, erase, read and background operations on the memory chip 220. The background operation may include, for example, at least one among garbage collection, wear leveling, read reclaim and bad block management operations.

The controller 300 may control the operation of the memory chip 220 according to a request of a device located outside the storage device 100. Also, the controller 300 may control the operation of the memory chip 220 regardless of a request from the outside.

For example, the controller 300 may control the operation of the memory chip 220 according to a request of a host device.

For example, the host device may be a computer, an ultra mobile PC (UMPC), a workstation, a personal digital assistant (PDA), a tablet, a mobile phone, a smartphone, an e-book, a portable multimedia player (PMP), a portable game player, a navigation device, a black box, a digital camera, a digital multimedia broadcasting (DMB) player, a smart television, a digital audio recorder, a digital audio player, a digital picture recorder, a digital picture player, a digital video recorder, a digital video player, a storage configuring a data center, one of various electronic devices configuring a home network, one of various electronic devices configuring a telematics network, an RFID (radio frequency identification) device, a mobility device (e.g., a vehicle, a robot or a drone) capable of driving under human control or autonomous driving, etc. Alternatively, the host device may be a virtual/augmented reality device which provides a 2D or 3D virtual reality image or augmented reality image. In addition, the host device may be any one of various electronic devices that require a storage device 100 capable of storing data.

The host device may include at least one operating system. The operating system may generally manage and control the function and operation of the host device and may control the interoperation between the host device and the storage device 100. The operating system may be classified into a general operating system and a mobile operating system depending on the mobility of the host device.

The controller 300 and the host device may be devices which are separated from each other. According to an embodiment of the disclosure, the controller 300 and the host device may be implemented by being integrated into one device. Hereunder, for the sake of convenience in explanation, it will be described as an example that the controller 300 and the host device are devices that are separated from each other.

The controller 300 may include a host interface, which provides an interface for communication with the host device. The controller 300 may include a memory interface, which provides an interface for communication with the memory chip 220.

The controller 300 may include a control circuit, which controls overall operations of the controller 300. The control circuit may include, for example, a processor. The control circuit may include a working memory that is used for the operation of the processor and may optionally include an error detection and correction circuit.

The processor may communicate with the host device through the host interface and may communicate with the memory chip 220 through the memory interface.

The processor may perform a function of interpreting a command input from the host device and transferring the command to the memory chip 220.

For example, the processor may include a flash translation layer or may correspond to a flash translation layer. The processor may translate a logical block address provided by the host device into a physical block address. The processor may receive a logical block address and translate the logical block address into a physical block address using a mapping table.

For example, the processor may execute firmware to control the operation of the controller 300. An operation of the storage device 100 to be described in an embodiment of the disclosed technology may be implemented in such a way that the processor executes firmware in which the corresponding operation is defined.

Firmware, as a program to be executed in the storage device 100 to drive the storage device 100, may include various functional layers corresponding to the processor described above. For example, the firmware may include binary data in which codes for executing the respective functional layers are defined.

For example, the firmware may be loaded into the working memory from the memory chip 220 or a separate nonvolatile memory (e.g., a ROM or a NOR Flash) located outside the memory chip 220. The processor may first load all or a part of the firmware in the working memory when executing a booting operation after power-on.

The processor may perform a logical operation which is defined in the firmware loaded in the working memory, to control the general operations of the controller 300. The processor may control the controller 300 to generate a command or a signal, according to a result of performing the logical operation defined in the firmware. When a part of firmware in which a logical operation to be performed is defined is not loaded in the working memory, the processor may generate an event (e.g., an interrupt) for loading the corresponding part of the firmware in the working memory.

The working memory may store firmware, program codes, commands, or data necessary to drive the controller 300. The working memory may be located inside or outside the controller 300. The working memory as, for example, a volatile memory, may include at least one among an SRAM (static RAM), a DRAM (dynamic RAM) and an SDRAM (synchronous DRAM). Working memories may be located inside and outside the controller 300.

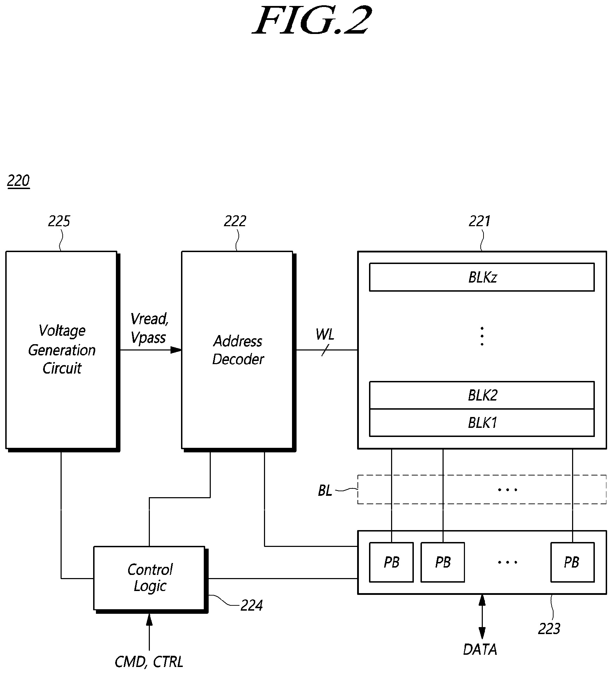

FIG. 2 is a diagram illustrating an example of the schematic configuration of the memory chip 220 included in the storage device 100 according to an embodiment of the disclosure.

Referring to FIG. 2, the memory chip 220 may include a memory cell array 221, an address decoder 222, a read and write circuit 223, a control logic 224 and a voltage generation circuit 225.

The memory cell array 221 may include a plurality of storage blocks BLK (i.e., BLK1 to BLKz, where z is a natural number of 2 or greater).

In the plurality of storage blocks BLK, a plurality of word lines WL and a plurality of bit lines BL may be disposed, and a plurality of memory cells may be arranged.

The plurality of storage blocks BLK may be coupled with the address decoder 222 through the plurality of word lines WL. The plurality of storage blocks BLK may be coupled with the read and write circuit 223 through the plurality of bit lines BL.

Each of the plurality of storage blocks BLK may include a plurality of memory cells. The plurality of memory cells may be nonvolatile memory cells and may be configured with nonvolatile memory cells, each of which has a vertical channel structure.

The memory cell array 221 may be configured with a memory cell array of a two-dimensional structure, or may be configured with a memory cell array of a three-dimensional structure.

Each of the plurality of memory cells included in memory cell array 221 may store at least 1-bit data. For instance, each of the plurality of memory cells included in memory cell array 221 may be a single-level cell (SLC) which stores 1-bit data. In another instance, each of the plurality of memory cells included in the memory cell array 221 may be a multi-level cell (MLC) that stores 2-bit data, a triple-level cell (TLC) that stores 3-bit data, a quad-level cell (QLC) that stores 4-bit data or a memory cell that stores 5 or more-bit data.

The number of bits of data stored in each of the plurality of memory cells may be dynamically determined. For example, a single-level cell that stores 1-bit data may be changed to a triple-level cell that stores 3-bit data.

The address decoder 222, the read and write circuit 223, the control logic 224 and the voltage generation circuit 225 may operate as a peripheral circuit that drives the memory cell array 221.

The address decoder 222 may be coupled to the memory cell array 221 through the plurality of word lines WL. The address decoder 222 may be configured to operate in response to the control of the control logic 224.

The address decoder 222 may receive an address through an input/output buffer in the memory chip 220. The address decoder 222 may be configured to decode a block address in the received address. The address decoder 222 may select at least one storage block BLK according to the decoded block address.

The address decoder 222 may receive a read voltage Vread and a pass voltage Vpass from the voltage generation circuit 225.

During a read operation, in an operation applying a read voltage, the address decoder 222 may apply the read voltage Vread to a selected word line WL in a selected storage block BLK and may apply the pass voltage Vpass to remaining unselected word lines WL.

In a program verify operation, the address decoder 222 may apply a verify voltage generated in the voltage generation circuit 225 to a selected word line WL in a selected storage block BLK and may apply the pass voltage Vpass to remaining unselected word lines WL.

The address decoder 222 may be configured to decode a column address in the received address. The address decoder 222 may transmit the decoded column address to the read and write circuit 223.

A read operation and a program operation of the memory chip 220 may be performed in the unit of page. An address received when each of the read operation and the program operation is requested may include at least one from among a block address, a row address and a column address.

The address decoder 222 may select one storage block BLK and one word line WL according to the block address and the row address. The column address may be decoded by the address decoder 222 and be provided to the read and write circuit 223.

The address decoder 222 may include at least one from among a block decoder, a row decoder, a column decoder, and an address buffer.

The read and write circuit 223 may include a plurality of page buffers PB. The read and write circuit 223 may operate as a read circuit in a read operation of the memory cell array 221, and may operate as a write circuit in a write operation of the memory cell array 221.

The read and write circuit 223, which includes the plurality of page buffers PB, may also be referred to as a page buffer circuit or a data register circuit. The read and write circuit 223 may include data buffers that take charge of a data processing function, and may further include cache buffers that take charge of a caching function.

The plurality of page buffers PB may be coupled to the memory cell array 221 through the plurality of bit lines BL. In a read operation and a program verify operation, the plurality of page buffers PB may continuously supply sensing current to bit lines BL coupled with memory cells to sense threshold voltages (Vth) of the memory cells, and may latch sensing data by sensing, through sensing nodes, changes in the amounts of current flowing according to the programmed states of the corresponding memory cells.

The read and write circuit 223 may operate in response to page buffer control signals output from the control logic 224.

In a read operation, the read and write circuit 223 may temporarily store read data by sensing data of memory cells, and then, may output data DATA to the input/output buffer of the memory chip 220. As an exemplary embodiment, the read and write circuit 223 may include a column select circuit in addition to the page buffers PB or the page registers.

The control logic 224 may be coupled with the address decoder 222, the read and write circuit 223 and the voltage generation circuit 225. The control logic 224 may receive a command CMD and a control signal CTRL through the input/output buffer of the memory chip 220.

The control logic 224 may be configured to control overall operations of the memory chip 220 in response to the control signal CTRL. The control logic 224 may output a control signal for adjusting the precharge potential level of the sensing nodes of the plurality of page buffers PB.

The control logic 224 may control the read and write circuit 223 to perform the read operation of the memory cell array 221. The voltage generation circuit 225 may generate the read voltage Vread and the pass voltage Vpass used in the read operation, in response to a voltage generation circuit control signal output from the control logic 224.

Each of the storage blocks BLK of the memory chip 220 described above may be configured with a plurality of pages corresponding to a plurality of word lines WL and a plurality of strings corresponding to a plurality of bit lines BL.

In a storage block BLK, a plurality of word lines WL and a plurality of bit lines BL may be disposed to intersect with each other. A memory cell that couples to one of the plurality of word lines WL and one of the plurality of bit lines BL may be defined. A transistor may be disposed in each memory cell.

The transistor disposed in the memory cell may include a drain, a source, and a gate. The drain (or source) of the transistor may be coupled to a corresponding bit line BL directly or via another transistor. The source (or drain) of the transistor may be coupled to a source line (which may be the ground) directly or via another transistor. The gate of the transistor may include a floating gate that is surrounded by a dielectric and a control gate to which a gate voltage is applied from a word line WL.

In each storage block BLK, a first select line (also referred to as a source select line or a drain select line) may be additionally disposed outside a first outermost word line WL more adjacent to the read and write circuit 223 between two outermost word lines WL, and a second select line (also referred to as a drain select line or a source select line) may be additionally disposed outside a second outermost word line WL between the two outermost word lines WL.

At least one dummy word line may be additionally disposed between the first outermost word line and the first select line. At least one dummy word line may also be additionally disposed between the second outermost word line and the second select line.

A read operation and a program operation (write operation) of the storage block BLK described above may be performed in the unit of page, and an erase operation may be performed in the unit of memory block.

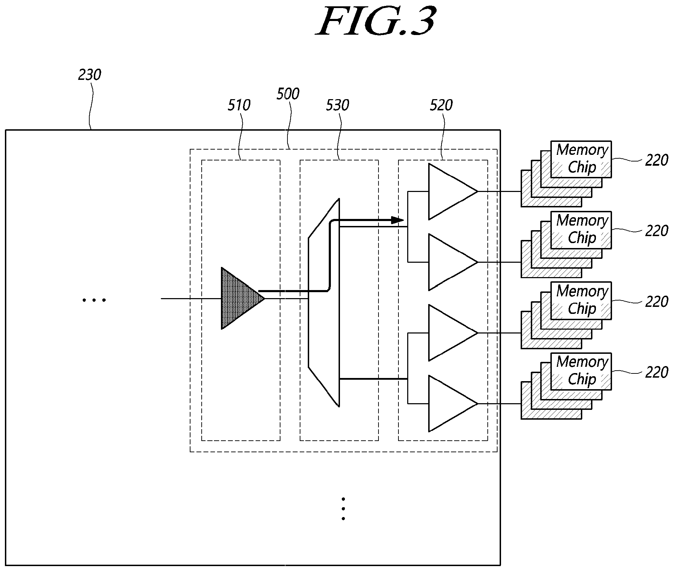

FIG. 3 is a diagram illustrating an example of the schematic configuration of the buffer chip 230 included in the storage device 100 according to an embodiment of the disclosure.

Referring to FIG. 3, the buffer chip 230 may receive a signal from the controller 300 of FIG. 1 and transmit the signal to the memory chip 220. The buffer chip 230 may transmit a signal received from the memory chip 220 to the controller 300.

The buffer chip 230 may include a plurality of input/output macros 500, which transmit and receive signals between the controller 300 and the memory chip 220.

For example, the plurality of input/output macros 500 may be disposed in areas, respectively, of the buffer chip 230 which are distinguished (not overlapped) from each other. For example, a first area where one of the plurality of input/output macros 500 is disposed is different from a second area where other one of the plurality of input/output macros 500 is disposed. The first area is distinguished from the second area, and the first area is not overlapped with the second area. Each of the plurality of input/output macros 500 may include an external input/output unit 510 and an internal input/output unit 520. In an embodiment, each of the plurality of input/output macros 500 may include a multiplexer 530, which connects the external input/output unit 510 and the internal input/output unit 520.

The external input/output unit 510 may receive a signal that is transmitted from the controller 300. The internal input/output unit 520 may transmit the received signal through the external input/output unit 510, to the memory chip 220.

The external input/output unit 510 and the internal input/output unit 520 may be configured with, for example, inverters, and may be located in the area of each of the plurality of input/output macros 500. The external input/output unit 510 and the internal input/output unit 520 may be electrically connected to each other in the areas of each of the plurality of input/output macros 500.

The plurality of memory chips 220 may be included in the memory package 200, and to transmit signals to the plurality of memory chips 220, a plurality of internal input/output units 520 may be disposed in the input/output macro 500.

Where the input/output macro 500 includes the plurality of internal input/output units 520, the multiplexer 530 for selecting an internal input/output unit 520. through which a signal received by the external input/output unit 510 is to be transferred, may be disposed in the input/output macro 500. For example, the multiplexer 530 may select an internal input/output unit 520 corresponding to a memory chip 220 to which a signal received from the controller 300 is to be transmitted, on the basis of a chip enable signal.

The structure of the buffer chip 230 may be implemented by the input/output macro 500 having a structure in which a signal received through the external input/output unit 510 is transmitted to the memory chip 220 through the internal input/output unit 520.

Since the external input/output unit 510 and the internal input/output unit 520 are electrically connected to each other within the area of each input/output macro 500, the distance between the external input/output unit 510 and the internal input/output unit 520 may decrease, and implementation of a routing structure for electrical connection between the external input/output unit 510 and the internal input/output unit 520 may be facilitated.

Buffer chip 230 can reduce signal delay due to capacitance formed in paths through which the signals are transmitted and received between the controller 300 and the memory chip 220 using the plurality of input/output macros 500.

A deviation in delay between signals transmitted and received between the controller 300 and the memory chip 220 may be prevented or reduced through setting of each of the plurality of input/output macros 500. The external input/output unit 510 included in each of the plurality of input/output macros 500 transfers a signal through the internal input/output unit 520, via training for setting each of the plurality of input/output macros 500.

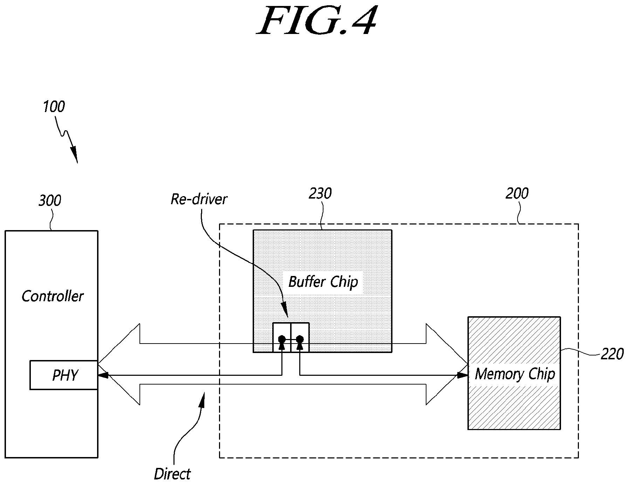

FIG. 4 is a diagram illustrating an example of a method of training the buffer chip 230, which transfers signals to be transmitted and received between the controller 300 and the memory chip 220 in the storage device 100 according to an embodiment of the disclosure.

Referring to FIG. 4, signals may be transmitted and received between the controller 300 and the memory chip 220 included in the storage device 100. The controller 300 may transmit a signal to the buffer chip 230, which is included in the memory package 200, through a physical layer.

The buffer chip 230 may include the plurality of input/output macros 500 each including the external input/output unit 510 and the internal input/output unit 520. Each input/output macro 500 may receive a signal from the controller 300 and transmit the signal to the memory chip 220.

Paths through which signals are transferred by the plurality of input/output macros 500, respectively, may be different from each other, and a deviation in capacitance of the respective paths may occur. In order to remove or reduce a deviation in signal delay between the plurality of input/output macros 500, training for setting each of the plurality of input/output macros 500 may be performed.

Since the input/output macro 500 included in the buffer chip 230 has a re-driver structure in which a signal is received from the controller 300 and is transmitted to the memory chip 220 without being separately processed, setting of the input/output macro 500 may be performed through transmission and reception of signals between the controller 300 and the memory chip 220.

Without separately performing training between the controller 300 and the buffer chip 230 and between the buffer chip 230 and the memory chip 220, setting of each of the plurality of input/output macros 500 for transmission and reception of signals may be performed through training on signals transmitted and received between the controller 300 and the memory chip 220. Through the training method, a deviation in delay of signals transmitted and received by each of the plurality of input/output macros 500 may be removed or reduced.

In this way, training for removing or reducing a deviation in delay of signals may be performed by the buffer chip 230 including the plurality of input/output macros 500 each of which is configured with the external input/output unit 510 and the internal input/output unit 520, and signal transmission and reception performance between the controller 300 and the memory chip 220 may be improved.

Since the external input/output unit 510 and the internal input/output unit 520 are disposed in each of the plurality of input/output macros 500, the routing structure between the external input/output unit 510 and the internal input/output unit 520 may also be implemented.

In addition, since the plurality of input/output macros 500 each of which is configured with the external input/output unit 510 and the internal input/output unit 520 are disposed in separate areas of the buffer chip 230 respectively, the disposition of package bumps which are connected to the external input/output unit 510 and the internal input/output unit 520 may be facilitated.

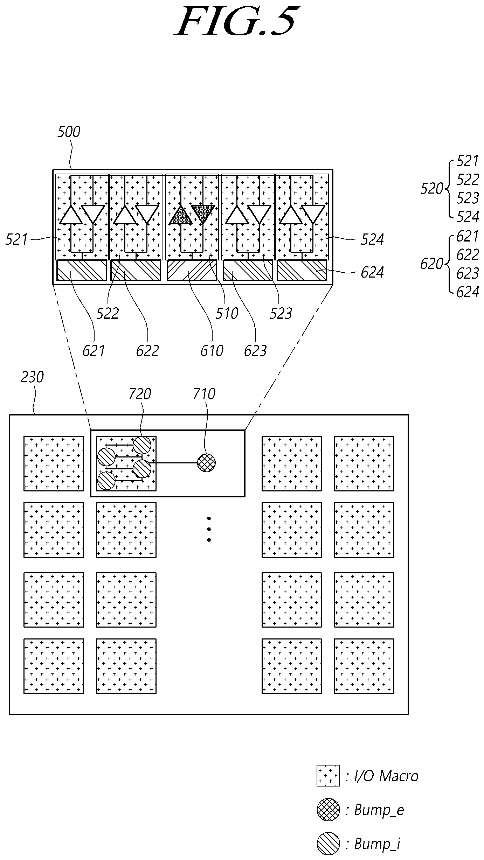

FIG. 5 is a diagram illustrating an example of a structure in which the input/output macros 500 are arranged in the buffer chip 230 according to an embodiment of the disclosure.

Referring to FIG. 5, in the buffer chip 230, the plurality of input/output macros 500 may be arranged, for example, in the form of tiles. The structure in which the plurality of input/output macros 500 are arranged in the form of tiles represents an example, and the plurality of input/output macros 500 may be disposed in a variety of ways while each having a structure in which the external input/output unit 510 and the internal input/output unit 520 are disposed to be located within the area of a corresponding input/output macro 500.

Each of the plurality of input/output macros 500 may be configured to include the external input/output unit 510 and the internal input/output unit 520.

According to an embodiment of the disclosure, each input/output macro 500 may be configured to include the internal input/output unit 520. The internal input/output unit 520 included in the input/output macro 500 may have a structure which is connected to the external input/output unit 510 located outside the input/output macro 500. Internal input/output units 520 which transmit the same type of signals may be disposed adjacent to each other, and an external input/output unit 510 may be located in a separate area.

By the internal input/output units 520 included in the input/output macro 500, the same type of signals may be transmitted to different memory chips 220 in the memory package 200. By the internal input/output units 520 included in different input/output macros 500, different types of signals may be transmitted to the same memory chip 220.

The internal input/output units 520 included in each input/output macro 500 may vary by the type of a signal transferred by the input/output macro 500 or the number of memory chips 220 included in the memory package 200.

For example, one external input/output unit 510 and four internal input/output units 521, 522, 523 and 524 may be disposed in the input/output macro 500. The external input/output unit 510 may receive a signal from the controller 300 by an external input/output pad 610. The internal input/output unit 520 may transmit a signal to the memory chip 220 through an internal input/output pad 620. Four internal input/output pads 621, 622, 623 and 624 may be electrically connected to four internal input/output units 521, 522, 523 and 524, respectively.

The external input/output pad 610 may be located inside the external input/output unit 510 or may be located outside the external input/output unit 510. The internal input/output pad 620 may be located inside the internal input/output unit 520 or may be located outside the internal input/output unit 520.

Since the external input/output unit 510 and the four internal input/output units 521, 522, 523 and 524 are located within the area of the input/output macro 500, connection between the external input/output unit 510 and the internal input/output unit 520 may be facilitated. Since the external input/output pad 610 and the internal input/output pad 620 are located within the area of the input/output macro 500, the input/output macro 500 may be implemented in a simple structure. For example, if a plurality of external input/output pads 610 are disposed in an area and gathered among themselves, and a plurality of internal input/output pads 620 are disposed in a different area and gathered among themselves, it could be difficult to connect between the external input/output pad 610 and the internal input/output pad 620, and a connection may be complicated. But according to the simple structure of the disclosure, a connection between the external input/output pad 610 and the internal input/output pad 620 may be implemented simply.

The external input/output unit 510 included in the input/output macro 500 may be electrically connected to Bump_e, an external package bump 710, which overlaps the area of the corresponding input/output macro 500. The internal input/output unit 520 included in the input/output macro 500 may be electrically connected to Bump_i, internal package bumps 720, which overlaps the area of the corresponding input/output macro 500.

Since the external package bump 710 and the internal package bumps 720 are respectively located to overlap the area of the corresponding input/output macro 500 and are electrically connected to the external input/output unit 510 and the internal input/output unit 520, the disposition of package bumps in the buffer chip 230 may be facilitated. The electrical connection between the package bumps and the input/output macro 500 may be realized in a simple structure. The external package bump 710 may be electrically connected to the external input/output unit 510 which is disposed on an area overlapping the external package bump 710. The internal package bump 720 may be electrically connected to the internal input/output unit 520 which is disposed on an area overlapping the internal package bump 720. The connection structure may be implemented simply.

As such, according to an embodiment of the disclosure, by the structure of the input/output macro 500 including the external input/output unit 510 and the internal input/output unit 520, training of the buffer chip 230 may be facilitated, and a signal transfer path or a package bump disposition structure may be implemented.

The structures of the external input/output unit 510 and the internal input/output unit 520 included in the input/output macro 500 may be various depending on the type of a signal transferred by the input/output macro 500.

For example, a data strobe signal DQS, a data signal DQ, a chip enable signal CE, a command latch enable signal CLE, an address latch enable signal ALE, a write enable signal WE, a read enable signal RE, and so on may be transferred by the buffer chip 230.

The chip enable signal CE may be a signal indicating that the memory chip 220 is operable. The command latch enable signal CLE may be a signal for receiving a command, and the address latch enable signal ALE may be a signal for receiving an address. The write enable signal WE may be a signal which is toggled when data including a command and an address is loaded in the memory chip 220. The read enable signal RE may be a signal which is toggled when data is loaded in the controller 300.

A signal to be transmitted by the input/output macro 500 may be transmitted in a single direction or in both directions between the controller 300 and the memory chip 220.

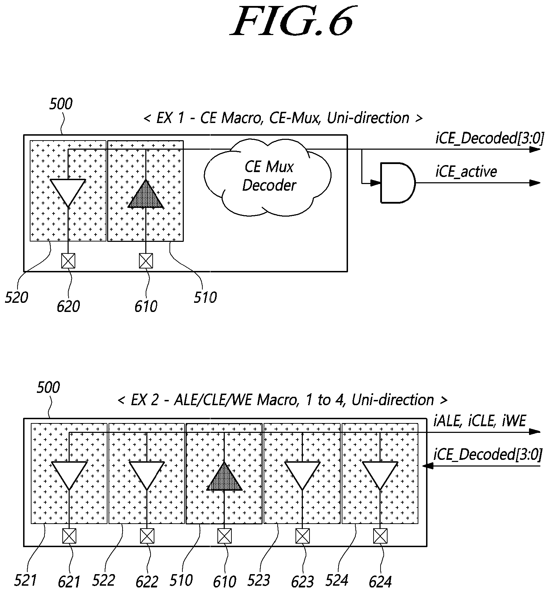

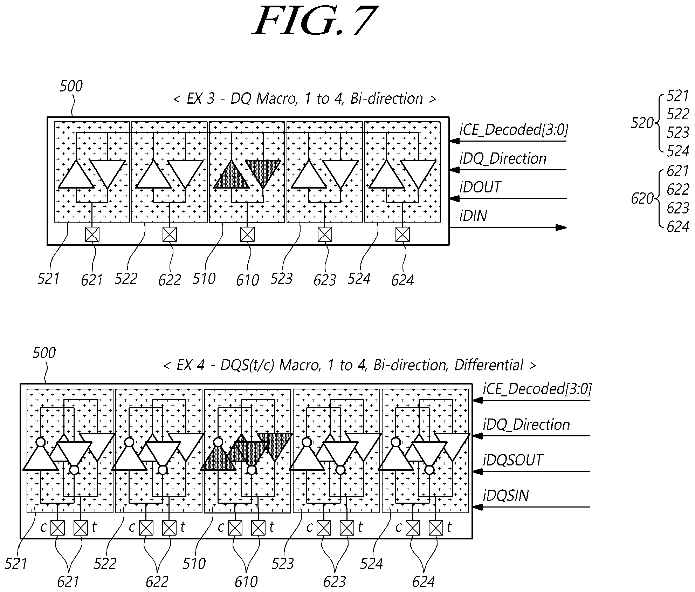

FIGS. 6 and 7 are diagrams illustrating examples of the input/output macros 500 included in the buffer chip 230 according to an embodiment of the disclosure. FIG. 6 illustrates examples of the structure of the input/output macro 500 when a signal transferred by the input/output macro 500 is a signal transmitted in a single direction. FIG. 7 illustrates examples of the structure of the input/output macro 500 when a signal transferred by the input/output macro 500 is a signal transmitted in both directions.

Referring to <EX 1> shown in FIG. 6, an example of the input/output macro 500 that transfers a chip enable signal CE is illustrated.

The input/output macro 500 may include an external input/output unit 510 and an internal input/output unit 520. The external input/output unit 510 and an external input/output pad 610 may be electrically connected, and the internal input/output unit 520 and an internal input/output pad 620 may be electrically connected.

The external input/output unit 510 and the internal input/output unit 520 may have a structure which transmits a signal in a single direction and may output a signal indicating activation of an internal chip enable signal iCE according to the chip enable signal CE. For example, decoded internal chip enable signal ICE_Decoded[3:0] may be input to the input/output macro 500, and may be used to indicate the memory chip 220 to be activated.

Referring to <EX 2> shown in FIG. 6, an example of the input/output macro 500 which transfers an address latch enable signal ALE, a command latch enable signal CLE and a write enable signal WE is illustrated.

Where four memory chips 220 are included in the memory package 200, the input/output macro 500 that transfers the above-described signals may include an external input/output unit 510, a first internal input/output unit 521, a second internal input/output unit 522, a third internal input/output unit 523 and a fourth internal input/output unit 524.

The external input/output unit 510 may be electrically connected to an external input/output pad 610. The first internal input/output unit 521 may be electrically connected to a first internal input/output pad 621. The second internal input/output unit 522, the third internal input/output unit 523 and the fourth internal input/output unit 524 may be electrically connected to a second internal input/output pad 622, a third internal input/output pad 623 and a fourth internal input/output pad 624, respectively.

The external input/output unit 510 and the four internal input/output units 521, 522, 523 and 524 may have a structure which transmits a signal in a single direction.

The input/output macro 500 may output an internal address latch enable signal iALE, an internal command latch enable signal iCLE and an internal write enable signal iWE according to the address latch enable signal ALE, the command latch enable signal CLE and the write enable signal WE.

In an embodiment of the disclosure, a data signal DQ or a data strobe signal DQS may be transmitted in both directions between the controller 300 and the memory chip 220, and the input/output macro 500 may be configured for such signal transfer.

Referring to <EX 3> shown in FIG. 7, an example of the input/output macro 500 which transfers a data signal DQ is illustrated. The input/output macro 500 may include an external input/output unit 510 capable of transmitting and receiving signals in both directions and an internal input/output unit 520 capable of transmitting and receiving signals in both directions. The input/output macro 500 may include the internal input/output unit 520 corresponding to the memory chip 220. For example, if the memory package 200 includes four memory chips 220, the internal input/output unit 520 may include four internal input/output unit 521, 522, 523, 524. According to the number of the memory chips 200 included in the memory package 200, the number of the internal input/output unit 520 may be changed.

The input/output macro 500 may receive, from the outside, a direction control signal which indicates a signal transmission/reception direction. The input/output macro 500 may transfer the data signal DQ while adjusting a direction for transmitting and receiving a signal, according to the direction control signal.

Referring to <EX 4> shown in FIG. 7, an example of the input/output macro 500 which transfers a data strobe signal DQS is illustrated. The input/output macro 500 may have a structure which transmits and receives differential signals. For example, each of a data strobe signal DQS c and a data strobe signal DQS t may be input to or output from each of two external input/output pads 610. Each of a data strobe signal DQS c and a data strobe signal DQS t may be input to or output from each of two internal input/output pads 620. When a differential signal or differential signals are transmitted and received by the input/output macro 500, a plurality of input/output pads may be electrically connected to each of the external input/output unit 510 and the internal input/output unit 520. The external input/output unit 510 may be electrically connected to two external input/output pads 610, and each of internal input/output units 520 may be electrically connected to two internal input/output pads 620. And for example, if the memory package 200 includes four memory chips 220, the internal input/output pads 620 may include four pairs of internal input/output pads 621, 622, 623, 624. According to the number of the memory chips 200 included in the memory package 200, the number of the internal input/output pads 620 may be changed.

A simple structure in which a signal is transferred in a single direction or both directions may be provided by the input/output macro 500. The path which signal is transmitted may be implemented simply. By the input/output macro 500, a structure capable of transmitting and receiving differential signals may be provided, and noise of a signal transferred by the buffer chip 230 may be reduced.

In an embodiment of the disclosure, the buffer chip 230 may include a control block for providing some signals related for control of the input/output macro 500.

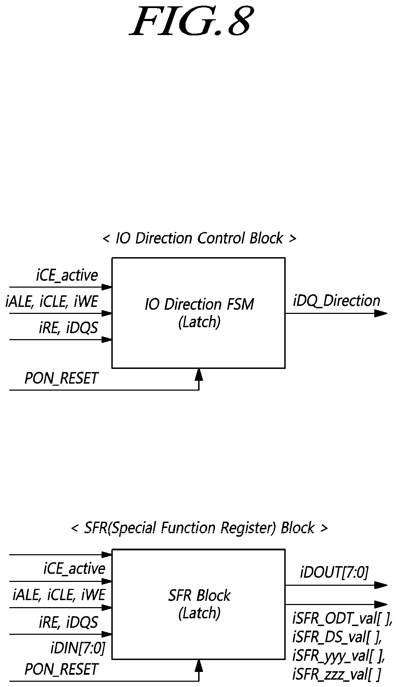

FIG. 8 is a diagram illustrating examples of control blocks included in the buffer chip 230 according to an embodiment of the disclosure.

Referring to FIG. 8, for example, the buffer chip 230 may include a direction control block which outputs a direction control signal.

The direction control block IO Direction Control Block may receive, for example, an internal chip enable signal iCE, an internal address latch enable signal iALE, an internal command latch enable signal iCLE, an internal write enable signal iWE, an internal read enable signal iRE and an internal data strobe signal iDQS, and may output a direction control signal which indicates the transmission direction of an internal data signal iDQ. The direction control block may receive a reset signal PON_RESET for the operation of the corresponding block.

The direction control signal may be inputted to the input/output macro 500. The input/output macro 500 may control a direction in which signals are transmitted and received between the controller 300 and the memory chip 220, according to the direction control signal.

For another example, the buffer chip 230 may include a special function register (SFR) block.

For example, the SFR block may receive a reset signal PON_RESET for an operation, may receive an internal chip enable signal iCE and so on. The SFR (Special Function Register) block may receive internal data and store information necessary for the operation of the buffer chip 230 or may output external data by performing an operation based on the internal data. The SFR block may tune an interface between the controller 300 and the memory chip 220. For example, the SFR block may store parameter values representing connection characteristics to the controller 300 or the memory chip 220. The SFR block may perform an interface tuning by controlling the parameter values.

The above-described direction control block and the SFR block may be located in an area other than the area where the input/output macro 500 is disposed in the buffer chip 230. Alternatively, the direction control block and the SFR block may be located in an area which overlaps the input/output macro 500.

In an embodiment of the disclosure, signal transmission and reception performance between the controller 300 and the memory chip 220 may be improved through training by the buffer chip 230 including the input/output macro 500 with the re-driver structure, and the operation of the input/output macro 500 may be supported by disposing some function blocks or the like in the buffer chip 230.

The input/output macro 500 of the buffer chip 230 may be disposed in the tile form described above or in various other forms and may be disposed in a form based on the type of a signal transferred by the input/output macro 500.

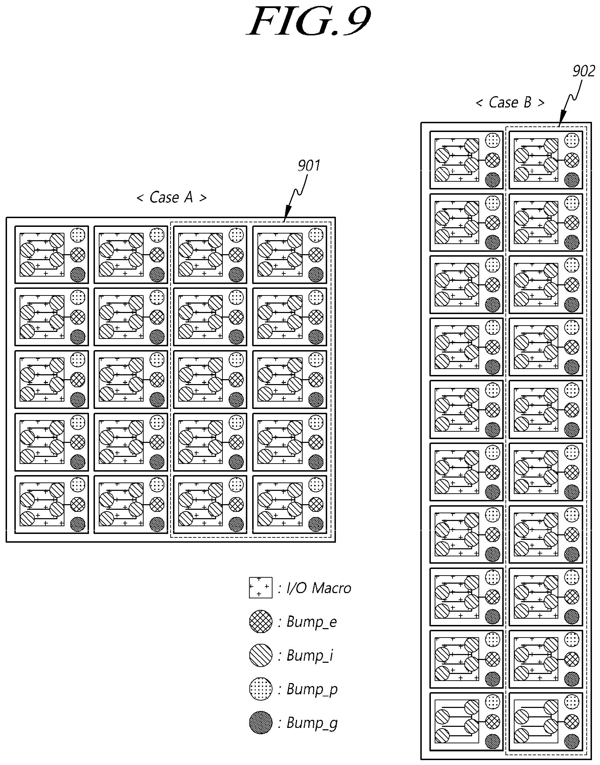

FIG. 9 is a diagram illustrating another example of the structure in which the input/output macros 500 are arranged in the buffer chip 230 according to an embodiment of the disclosure.

Referring to FIG. 9, a plurality of input/output macros 500 included in the buffer chip 230 may be arranged in the form of tiles. For example, the plurality of input/output macros 500 may be disposed in a 4X5 tile form as in <Case A>, or may be disposed in a 2X10 tile form as in <Case B>.

In the area of each input/output macro 500, an external package bump Bump_e which is electrically connected to an external input/output unit 510, an internal package bump Bump_i which is electrically connected to an internal input/output unit 520, etc. may be disposed, and a power bump Bump_p supplied with power, a ground bump Bump_g grounded, etc. may be disposed. FIG. 9 illustrates an example of a position of the power bump Bump_p and a position of the ground bump Bump_g, and the position of the power bump Bump_p and the position of the ground bump Bump_g are not limited to this.

The input/output macros 500 arranged in the buffer chip 230 may be disposed by being distinguished according to the types of signals transferred by the input/output macros 500.

For example, in <Case A>, when an area indicated by 901 is an area closer to the memory chip 220, high-speed signals may be transferred through the input/output macros 500 which are disposed in the area indicated by 901. For example, data signals DQ or read enable signals RE may be transmitted and received through the input/output macros 500 which are disposed in the area indicated by 901. Signals which operate at low speeds, such as a chip enable signal CE, a write enable signal WE, an address latch enable signal ALE and a command latch enable signal CLE, may be transmitted and received through the input/output macros 500 which are disposed in an area other than the area indicated by 901.

In the case of <Case B>, high-speed signals such as a data signal DQ and a read enable signal RE may be transmitted and received through the input/output macros 500 which are disposed in an area indicated by 902. Low-speed signals such as a chip enable signal CE, a write enable signal WE, an address latch enable signal ALE and a command latch enable signal CLE may be transmitted and received through the input/output macros 500 which are disposed in an area other than the area indicated by 902.

According to the disposition of the input/output macros 500, the signal transmission/reception paths between the buffer chip 230 and the memory chip 220 may be reduced to improve high-speed signal transmission/reception performance.

In addition, according to an embodiment of the disclosure, as the external input/output unit 510 and the internal input/output unit 520, which transfer the same type of signals, are located in the area of a corresponding input/output macro 500, it is possible to provide a structure capable of reducing delay by signal transmission and reception paths between the buffer chip 230 and the memory chip 220.

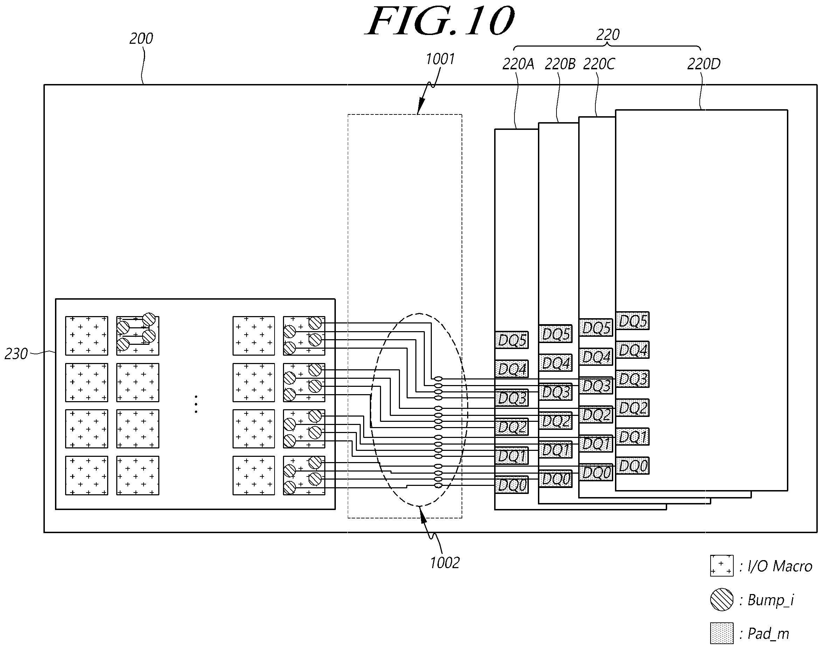

FIG. 10 is a diagram illustrating an example of a structure in which the buffer chip 230 and the memory chip 220 are connected in the memory package 200 according to an embodiment of the disclosure.

Referring to FIG. 10, a structure in which a buffer chip 230 and four memory chips 220 are disposed in a memory package 200 is illustrated as an example. The structure may be a structure in which a second memory chip220B, a third memory chip 220C, and a fourth memory chip 220D are sequentially stacked on a first memory chip220A.

Internal package bumps Bump_i of input/output macros 500 included in the buffer chip 230 may be electrically connected to memory pads Pad_m of the memory chips 220. FIG. 10 illustrates, as an example, portions where the input/output macros 500 of the buffer chip 230 are electrically connected to the memory pads Pad_m to which data signals DQ are applied. The input/output macros 500, which are electrically connected to the memory pads Pad_m to which the data signals DQ are applied, may be located in an area of the buffer chip 230 adjacent to the memory chip(s) 220.

The internal package bumps Bump_i of the input/output macros 500 may be connected to the interconnections of a package substrate 210 in an area indicated by 1001. The internal package bumps Bump_i of the input/output macros 500 may be electrically connected to the memory pads Pad_m of the memory chips 220 through the interconnections of the package substrate 210.

The internal package bumps Bump_i included in the input/output macros 500 may be electrically connected to the memory pads Pad_m through which the same type of signals is inputted. For example, the internal package bumps Bump_i included in the input/output macros 500 may be electrically connected to the memory pads Pad_m through which data signals DQ are inputted in the different memory chips 220.

Since the same type of signals are transmitted to the different memory chips 220 through the internal package bumps Bump_i included in the respective input/output macros 500, as in a portion indicated by 1002, signal transmission/reception paths between the input/output macros 500 of the buffer chip 230 and the memory pads Pad_m of the memory chips 220 may be formed without crossing each other.

While signal interference caused due to crossing of paths through which signals are transmitted and received between the buffer chip 230 and the memory chips 220 is prevented, minimized, or reduced, thereby signal transmission and reception performance by the buffer chip 230 may be improved.

Although various embodiments of the disclosed technology have been described with particular specifics and varying details for illustrative purposes, those skilled in the art will appreciate that various modifications, additions and substitutions may be made based on what is disclosed or illustrated in the disclosed technology without departing from the spirit and scope of the disclosed technology as defined in the following claims.

## Claims

1. A storage device comprising:
at least one memory chip;
a controller configured to control the at least one memory chip; and
a buffer chip configured to transfer a plurality of signals between the controller and the at least one memory chip,
wherein the buffer chip comprises a plurality of input/output macros, each of the plurality of input/output macros comprises an external input/output unit which receives a signal from the controller and an internal input/output unit which transmits the signal to the at least one memory chip, and each of the external input/output unit and the internal input/output unit is electrically connected with a bump that overlaps an area of each of the plurality of input/output macros.

2. The storage device according to claim 1, wherein each of the plurality of input/output macros is arranged in a form of a tile in the buffer chip.

3. The storage device according to claim 1, wherein the external input/output unit and the internal input/output unit are electrically connected to each other in an area overlapping each of the plurality of input/output macros.

4. The storage device according to claim 1, wherein a power bump and a ground bump are located in the area of each of the plurality of input/output macros.

5. The storage device according to claim 1, wherein a plurality of internal input/output units are included in at least one of the plurality of input/output macros, and the plurality of internal input/output units transmit the signals to different memory chips, respectively.

6. The storage device according to claim 5, wherein a plurality of same types of the signals are transmitted through the plurality of internal input/output units.

7. The storage device according to claim 5, wherein the buffer chip further comprises a multiplexer configured to electrically connect the external input/output unit to the plurality of internal input/output units.

8. The storage device according to claim 1, wherein a type of a signal transmitted to the at least one memory chip through a first input/output macro among the plurality of input/output macros is different from a type of a signal transmitted to the at least one memory chip through a second input/output macro.

9. The storage device according to claim 1, wherein the signal is transmitted in a single direction from the external input/output unit to the internal input/output unit in at least one of the plurality of input/output macros.

10. The storage device according to claim 1, wherein the signals are transmitted in both directions between the external input/output unit and the internal input/output unit in at least one of the plurality of input/output macros.

11. The storage device according to claim 1, wherein at least one of the plurality of input/output macros receives a direction control signal which controls a direction in which the signal is transmitted.

12. The storage device according to claim 1, wherein at least one of the plurality of input/output macros receives a differential signal through the external input/output unit and transmits the differential signal through the internal input/output unit.

13. A memory package comprising:
a package substrate;
at least one memory chip on the package substrate; and
a buffer chip located on the package substrate and comprising a plurality of input/output macros which transmit and receive signals to and from the at least one memory chip, wherein each of the plurality of input/output macros comprises an external input/output unit which receives a signal from outside the buffer chip and an internal input/output unit which is electrically connected to the external input/output unit in an area of each of the plurality of input/output macros and transmits the signal to the at least one memory chip.

14. The memory package according to claim 13, wherein each of the external input/output unit and the internal input/output unit is electrically connected to a bump that overlaps the area of each of the plurality of input/output macros.

15. The memory package according to claim 13, wherein a plurality of bumps which overlap the area of each of the plurality of input/output macros are electrically connected to different memory chips, respectively.

16. The memory package according to claim 13, wherein the buffer chip comprises a direction control block which controls a direction in which the signal is transmitted in at least one of the plurality of input/output macros.

17. A storage device trained to reduce deviations in delay of signals comprising:
at least one memory package having a signal interface trained to reduce input and output signal delay; and
a controller configured to control the at least one memory package,
wherein the at least one memory package further comprises at least one memory chip and a buffer chip for implementing the signal interface between the at least one memory chip and the controller.

18. The storage device of claim 17, wherein the buffer chip further comprises a plurality of input/output macros having at least one setting to minimize a deviation in a delay between a plurality of signals transmitted and received between the controller and the at least one memory chip.

19. The storage device of claim 18, wherein the at least one setting of the plurality of input/output macros are trained to minimize the deviation in the delay between the plurality of signals transmitted and received between the controller and the at least one memory chip.

20. The storage device of claim 19, wherein the plurality of input/output macros further comprise a plurality of package bump interconnections to a package substrate for signal transmission/reception paths indicated by a first area disposed between the plurality of input/output macros of the buffer chip and a plurality of memory pads of a memory chip, and
wherein a plurality of signal transmission/reception paths between the plurality of input/output macros of the buffer chip and the plurality of memory pads of the memory chip connect in a portion indicated by a second area, wherein the signal transmission/reception paths in the second area do not cross each other.
